# EUROPÄISCHE PATENTSCHRIFT

(11) **EP 4 314 926 B1**
(45) Veröffentlichungstag und Bekanntmachung des Hinweises auf die Patenterteilung: **18.06.2025**
(21) Anmeldenummer: 22712381.7
(22) Anmeldetag: 10.03.2022
(51) Int. Cl.: G02B 13/14, G02B 5/08, G03F 7/20, G03F 7/00, G02B 27/00

(54) **OPTISCHE ANORDNUNG FÜR DEN FUV/VUV-WELLENLÄNGENBEREICH**
OPTICAL ARRANGEMENT FOR THE FUV/VUV-WAVELENGTH RANGE
AGENCEMENT OPTIQUE POUR LA PLAGE DE LONGUEURS D'ONDE DU FUV/VUV

(30) Priorität: 24.03.2021 DE 102021202848
(43) Veröffentlichungstag der Anmeldung: 07.02.2024
(73) Patentinhaber: Carl Zeiss SMT GmbH, 73447 Oberkochen (DE)
(72) Erfinder: LANGE, Felix, 89537 Giengen an der Brenz (DE); WALTER (GEB. MEYER), Larissa, 73434 Aalen (DE)
(74) Vertreter: Kohler Schmid Möbus Patentanwälte
(86) Internationale Anmeldenummer: PCT/EP2022/056133
(87) Internationale Veröffentlichungsnummer: WO 2022/200054

(56) Entgegenhaltungen:
- WO-A2-2020/115112
- DE-A1- 102018 211 498

## Beschreibung

### Bezugnahme auf verwandte Anmeldung

Diese Anmeldung beansprucht die Priorität der deutschen Patentanmeldung DE 10 2021 202 848.9 vom 24. März 2021.

### Hintergrund der Erfindung

Die Erfindung betrifft eine optische Anordnung für den FUV/VUV-Wellenlängenbereich, insbesondere ein Wafer-Inspektionssystem oder eine FUV/VUV-Lithographieanlage, die einen Innenraum aufweist, wobei in dem Innenraum mindestens ein transmittierendes optisches Element zur Transmission von Strahlung im FUV/VUV-Wellenlängenbereich angeordnet ist, welches bevorzugt ein kristallines, insbesondere ionisches Substrat aufweist, und/oder wobei in dem Innenraum mindestens ein reflektierendes optisches Element zur Reflexion von Strahlung im FUV/VUV-Wellenlängenbereich angeordnet ist, das ein Substrat und eine reflektierende Beschichtung aufweist, eine Strahlungsquelle zur Bestrahlung des mindestens einen optischen Elements mit Strahlung im FUV/VUV-Wellenlängenbereich sowie mindestens einen Gaseinlass zur Zuführung mindestens eines Gases in den Innenraum. Unter dem VUV-Wellenlängenbereich wird im Sinne dieser Anmeldung ein Wellenlängenbereich zwischen 100 nm und 200 nm verstanden (VUV-Wellenlängenbereich nach DIN 5031 Teil 7). Unter dem FUV-Wellenlängenbereich wird im Sinne dieser Anmeldung ein Wellenlängenbereich zwischen 200 nm und ca. 280 nm verstanden. Die hier beschriebene optische Anordnung kann zum Betrieb für den VUV-Wellenlängenbereich, zum Betrieb für den FUV-Wellenlängenbereich oder zum Betrieb in beiden Wellenlängenbereichen ausgebildet bzw. konfiguriert sein.

Zur Inspektion von kleinsten Strukturen an einem Wafer mittels eines Wafer-Inspektionssystems ist es günstig, die bislang für die Inspektion verwendeten Wellenlängen im FUV-Wellenlängenbereich zu kleineren Wellenlängen im VUV-Wellenlängenbereich abzusenken, vgl. beispielsweise den Artikel "Extending Optical Inspection to the VUV", Keith Wells et al., Int. Conf. on Frontiers of Characterization and Metrology for Nanoelectronics (FCMN), 2017, Seiten 92-101 oder die US 2016/0258878 A1, die ein Wafer-Inspektionssystem für den VUV-Wellenlängenbereich zum Gegenstand hat.

Wie in dem oben zitierten Artikel beschrieben ist, sind für den Betrieb eines Wafer-Inspektionssystems bei Wellenlängen im VUV-Wellenlängenbereich große Herausforderungen zu überwinden. Beispielsweise zeigen hochreflektierende Spiegel, die bei VUV-Wellenlängen traditionell aus Aluminium gefertigt werden, bei hohen Bestrahlungsstärken eine erhebliche Abnahme ihrer Reflektivität, auch wenn die Al-Oberfläche mit dielektrischen Materialien, z.B. mit fluoridischen Materialien wie MgF₂, geschützt wird, wie dies z.B. in der US 2017/0031067 A1 oder in der US 2004/0006249 A1 beschrieben ist. In der DE102019219177.0 wird vorgeschlagen, zur Lösung dieses Problems ein Mangin-Spiegel für den VUV-Wellenlängenbereich zu verwenden.

In der DE 10 2018 211 498 A1 ist ein optisches Element beschrieben, das eine reflektive Fläche umfasst, die eine Schutzschicht aus Fluoriden aufweist. Das optische Element kann für den VUV-Wellenlängenbereich ausgelegt sein. Die reflektive Fläche kann als Beschichtung auf einem Substrat ausgebildet sein und eine Metallschicht aufweisen, bei der es sich insbesondere um eine Schicht aus Aluminium oder eine Aluminiumlegierung handeln kann.

Neben reflektierenden optischen Elementen werden in optischen Anordnungen für den FUV/VUV-Wellenlängenbereich auch transmittierende optische Elemente verwendet. Optische Elemente, die zur Transmission von FUV/VUV-Strahlung ausgebildet sind, weisen häufig ein Material bzw. ein Substrat in Form eines ionischen (Ein-)Kristalls, beispielsweise eines fluoridischen (Ein- )Kristalls, auf. Die Bestrahlung derartiger optischer Elemente mit hohen Bestrahlungsstärken im FUV/VUV-Wellenlängenbereich kann zu Defekten in Form von Farbzentren, z.B. in Form von F-Zentren, führen, vgl. beispielsweise den Artikel "The radiation damage process in MgF2", M. R. Buckton and D. Pooley, J. Phys. C: Solid State Phys. 5 (1972), Seiten 1553-1563 oder den Artikel "Swelling and creation of color centers in MgF2 single crystals irradiated with energetic heavy ions", A.S. El-Said et al., Nucl. Instr. Meth. B 245 (2006), Seiten 250-254. Die Bildung der Farbzentren führt zu einer erhöhten Absorption der FUV/VUV-Strahlung im Material des ionischen Kristalls, z.B. in MgF₂.

Bei der Bestrahlung eines kristallinen Materials, insbesondere eines ionischen Kristalls, mit energiereicher Strahlung im FUV- oder VUV-Wellenlängenbereich kann es zudem zu einem erheblichen Energieeintrag in die Oberfläche des kristallinen Materials kommen. Dieser Energieeintrag kann zu einer unerwünschten Veränderung der Geometrie der Oberfläche (Degradation) führen. Eine Oberfläche besitzt gegenüber dem Volumen eines Festkörpers einen energetisch ungünstigeren Zustand. Zudem können durch die (End-) Bearbeitung bei der Herstellung der Oberfläche (Schleifen, Polieren, ...) Störungen in die Oberfläche eingetragen werden, die besondere Schwachstellen darstellen. Insbesondere tritt dieses Problem bei der Bestrahlung einer nicht perfekten Oberfläche mit energiereicher Strahlung auf, da eine solche Oberfläche eine erhöhte Absorption aufweist, so dass dort ein deutlich größerer Energieeintrag auftritt als im Volumen des Substrats des optischen Elements.

In der US 6,495,202 B2 wird vorgeschlagen, an einem optischen Element, das zumindest in einem oberflächennahen Bereich Fluor aufweist, die Fluor-Atome durch OH-Gruppen und/oder durch O-Atome zu ersetzen. In der US 6,269,661 B1 wird vorgeschlagen, die Transmission eines optischen Bauteils durch eine Wärmebehandlung und eine Ätzbehandlung an einer Oberfläche zu erhöhen, an der das Bauteil aus einem Block-Material, z.B. in Form von CaF₂, geschnitten wurde. Aus der WO 2019/007927 A1 ist es bekannt, durch einen Atomlagen-Ätzprozess eine Kontaminationsschicht zumindest teilweise von einer optischen Oberfläche eines optischen Elements zu entfernen.

In der WO 2020/115112 A2 ist eine optische Anordnung in Form eines Wafer-Inspektionssystems der eingangs genannten Art beschrieben. Das Wafer-Inspektionssystem weist einen Gaseinlass auf, der zur Zuführung eines Adsorbats, insbesondere von Wasser, in den Innenraum zumindest während der Bestrahlung der Oberfläche ausgebildet bzw. konfiguriert ist. Durch die Zuführung des Adsorbats zur Oberfläche eines optischen Elements soll die Degradation der Oberfläche abgemildert werden: Das Adsorbat kann einen Anteil der Wärmeenergie, die durch Absorption von Strahlung an der Oberfläche entsteht, aufnehmen und durch Desorption abführen, wobei Verdunstungskälte entsteht. Dies führt dazu, dass an der Oberfläche weniger Energie für Umlagerungseffekte und andere die Oberfläche schädigende Effekte zur Verfügung steht.

In der PCT/EP2019/083632 ist beschrieben, dass es sich für den Fall, dass es sich bei dem Substrat um einen ionischen Kristall handelt, die Zuführung eines polaren Adsorbats, d.h. eines Adsorbats, welches ein hohes Dipolmoment aufweist, als günstig erwiesen hat. Da die Oberflächen ionischer Kristalle, die eine erhöhte Oberflächenenergie aufweisen, typischerweise einen Dipolcharakter haben, können die Dipole an diesen Oberflächen durch die Anlagerung von Molekülen gesättigt werden, die ein Dipolmoment aufweisen. In der PCT/EP2019/083632 ist angegeben, dass sich aufgrund seines großen Dipolmoments Wasser anbietet. Um die gewünschte Wirkung zu erzielen, ist eine Mindestkonzentration von Wasser in dem Innenraum erforderlich, die bei mehr als 1 ppm oder bei mehr als 10 ppm (in Bezug auf den Gesamt-Druck) liegen soll.

Es wurde beobachtet, dass bei den oben angegebenen Konzentrationen von Wasser in dem Innenraum bei hohen Bestrahlungsstärken im FUV- und insbesondere im VUV-Wellenlängenbereich funktionale optische Schichten bzw. Komponenten geschädigt werden können. Beispielsweise hat sich gezeigt, dass ein in dem Innenraum angeordnetes reflektierendes optisches Element in Form eines dielektrisch geschützten Aluminium-Spiegels eine erhebliche Abnahme der Reflektivität zeigt.

### Aufgabe der Erfindung

Aufgabe der Erfindung ist es, eine optische Anordnung bereitzustellen, welche der Degradation von transmittierenden und/oder von reflektierenden optischen Elementen bei der Bestrahlung mit Strahlung im DUV/VUV-Wellenlängenbereich entgegengewirkt.

### Gegenstand der Erfindung

Diese Aufgabe wird gelöst durch eine optische Anordnung der eingangs genannten Art, bei welcher der Gaseinlass zur Zuführung von Ammoniak (NH₃) in den Innenraum zumindest während der Bestrahlung der Oberfläche ausgebildet ist.

Ammoniak ist wie Wasser (H₂O) ein permanenter Dipol mit einem vergleichbar großen Dipolmoment (Dipolmomente: H₂O = 1,85 D, NH₃ = 1,47 D). Durch das Zudosieren von Ammoniak in den Innenraum kann daher dieselbe Wirkung auf die Oberfläche des Substrats bzw. des ionischen Kristalls eines transmittierenden optischen Elements erzeugt werden wie beim Zudosieren von Wasser. Wie nachfolgend beschrieben wird, können jedoch die negativen Effekte von Wasser auf funktionale optischen Schichten bzw. Komponenten vermieden werden, wenn Stelle von Wasser Ammoniak in den Innenraum zugeführt wird. Auch bei reflektierenden optischen Elementen kann sich das Zuführen eines polaren Adsorbats vorteilhaft auswirken, beispielsweise wenn diese als Rückflächenspiegel ausgebildet sind, bei denen beispielsweise eine Aluminium-Schicht auf die Rückseite eines transparenten Trägermaterials in Form eines Fluorids, z.B. in Form von MgF₂, aufgebracht ist.

Wasser wird unter Bestrahlung mit UV-Strahlung, insbesondere mit VUV-Strahlung bei Wellenlängen zwischen 115 nm und 160 nm, photochemisch sehr effizient aufgespalten (Wirkungsgrad nahezu 1), wodurch hochreaktive Sauerstoff- und/oder Hydroxid-Radikale und/oder Ionen entstehen.

Zwei dieser photochemischen Reaktionen sind nachfolgend angegeben:

H₂O + *hv* → H* + OH*

H₂O + *hv* → H₂ + O*

Diese oxidischen/hydroxidischen Reaktionsprodukte können im Folgenden funktionale optische Schichten und/oder Komponenten oxidieren, beispielsweise Al-Spiegel unter Bildung von Al₂O₃, Al(OH)₃.

Im Gegensatz dazu sind die durch VUV-Strahlung induzierten photochemischen Reaktionsprodukte von NH₃ deutlich reaktionsärmer.

Zwei der photochemischen Reaktionen von NH₃ sind nachfolgend angegeben:

NH₃ + *hv* → NH₂* + H

NH₃ + *hv* → NH* + H₂

Die oben angegebenen photochemischen Reaktionsprodukte unter FUV/VUV-Bestrahlung sind sauerstofffrei und reaktionsarm in Bezug auf Materialien wie Fluoride oder Metalle wie Aluminium. Eine direkte chemische Reaktion von Metallen wie z.B. Aluminium mit diesen Reaktionsprodukten ist bei einer hinreichend trockenen Restgas-Atmosphäre in dem Innenraum daher unwahrscheinlich.

Bei einer Ausführungsform weist die optische Anordnung eine Einstelleinrichtung zur Einstellung eines Gehalts des Ammoniaks in dem Innenraum auf. Um mit dem Ammoniak die gewünschte Wirkung zu erzielen, die Degradation der Oberfläche des transmittierenden optischen Elements zu verhindern, ist typischerweise eine Mindestkonzentration des Ammoniaks in dem Innenraum erforderlich. Die Konzentration des Ammoniaks sollte aber auch nicht zu groß gewählt werden, um zu verhindern, dass die Strahlung innerhalb des Gas-Volumens des Innenraums teilweise von dem Ammoniak absorbiert wird und somit die Transmission der optischen Anordnung abnimmt.

Die Einstelleinrichtung dient dazu, die Konzentration bzw. den Gehalt des Ammoniaks in dem Innenraum zumindest während der Bestrahlung in einem vorgegebenen Wertebereich zu halten. Die Zuführung des Adsorbats in den Innenraum ist typischerweise nur erforderlich, während die Oberfläche belastet, d.h. bestrahlt, wird. Die Einstelleinrichtung kann daher in den Betriebspausen die Zuführung des Ammoniaks verhindern. Die Einstelleinrichtung kann mit einer Dosiereinrichtung in Verbindung stehen, die es ermöglicht, die Menge des über den Gaseinlass in den Innenraum zugeführten Ammoniaks einzustellen. Bei der Dosiereinrichtung kann es sich beispielsweise um ein steuerbares Ventil handeln, welches eine Dosierung des Ammoniak-Gehalts in dem Innenraum im ppm-Bereich ermöglicht.

Der Gaseinlass bzw. das Gaseinlasssystem für die Zuführung des Ammoniaks in den Innenraum weist erfindungsgemäß auch ein Reservoir auf, in dem der Ammoniak enthalten ist. Bei der Anlagerung des Ammoniaks an der Oberfläche handelt es sich um einen reversiblen Prozess.

Bei einer Weiterbildung umfasst die optische Anordnung eine Messeinrichtung (einen Sensor) zum Messen einer Konzentration des Ammoniaks in dem Innenraum. Die Messeinrichtung misst die Ist-Konzentration des Ammoniaks in dem Innenraum, insbesondere in der Nähe der Oberfläche. Die Einstelleinrichtung ist in diesem Fall typischerweise zur Regelung der Konzentration des Ammoniaks in dem Innenraum ausgebildet. Mit Hilfe einer Regeleinrichtung bzw. einem in der Einstelleinrichtung vorgesehenen Regler kann der mittels der Messeinrichtung gemessene Ist-Wert der Ammoniak-Konzentration auf einen Soll-Wert geregelt werden.

Die Konzentration bzw. der Gehalt des Ammoniaks kann absolut gemessen werden, beispielsweise in Form des Partialdrucks, oder relativ, d.h. in Bezug auf den Gesamtdruck oder auf das Gesamt-Volumen/die Gesamt-Teilchenzahl in dem Innenraum. Nachfolgend wird für die Definition des Gehalts des Ammoniaks in dem Innenraum das Verhältnis des Volumens des Ammoniaks zum Gesamt-Volumen verwendet (Volumen-Mischungsverhältnis, Einheit: ppmV).

Die in-situ Messeinrichtung sollte ausgebildet sein, den Gehalt des Ammoniaks in dem Innenraum mit einer Genauigkeit in der Größenordnung von 1 ppmV, idealerweise mit einer Genauigkeit von 100 ppbV, zu messen. Als in-situ Messeinrichtung kann beispielsweise ein Restgasanalysator dienen, der ein Massenspektrometer aufweist. Auch ein elektrochemischer Sensor oder ein durchstimmbarer (tunable) Diodenlaser zur photoakustischen Analyse bzw. Spektroskopie kann als in-situ Messeinrichtung verwendet werden.

Bei einer weiteren Ausführungsform ist Ammoniak mit einer Konzentration von mehr als 0,1 ppmV, bevorzugt von mehr als 1 ppmV, in den Innenraum eingebracht. Eine Mindest-Konzentration von Ammoniak, die größer ist als die angegebenen Werte ist für Substrate in Form von ionischen Kristallen in der Regel ausreichend, um eine Degradation der Oberfläche durch eine Umlagerung zu verhindern. In der Regel sollte eine maximale Konzentration von Ammoniak in dem Innenraum von mehr als ca. 10 ppmV nicht überschritten werden, um eine zu starke Absorption der Strahlung zu verhindern.

Bei einer weiteren Ausführungsform ist die optische Anordnung zur Zuführung mindestens eines Inertgases in den Innenraum ausgebildet, die insbesondere über denselben Gaseinlass erfolgt wie die Zuführung des Ammoniaks, die aber ggf. auch über einen anderen Gaseinlass erfolgen kann. Der Innenraum kann beispielsweise in einem Gehäuse der optischen Anordnung, z.B. einem Wafer-Inspektionssystem oder einer Lithographieanlage, gebildet sein. Bei dieser Ausführungsform herrscht in dem Innenraum in der Regel ein vergleichsweise großer Gesamt-Druck, typischerweise in der Nähe von Atmosphärendruck, der im Wesentlichen durch den Partial-Druck des Inertgases bestimmt wird. Bei dem Inertgas kann es sich beispielsweise um ein Edelgas, z.B. um He, Ne, Ar, Kr, Xe oder um Stickstoff (N₂) handeln.

Bei einer Weiterbildung ist der Gaseinlass ausgebildet, den Ammoniak und das Inertgas als Gasgemisch in den Innenraum einzubringen. Dies ist günstig, da es sich bei Ammoniak um ein toxisches Gas handelt. Durch die Verwendung eines Gasgemisches aus NH₃ und dem Inertgas, z.B. Ar, ist es möglich, den für den Arbeitsschutz vorgeschriebenen MAK-Wert (Maximale Arbeitsplatz-Konzentration) für die Konzentration von Ammoniak am Arbeitslatz von 20 ppmV nicht zu überschreiten. Aufgrund der Toxizität des Ammoniaks ist ggf. die Installation eines Überwachungssystems für Ammoniak in dem (Labor-)Bereich erforderlich, der die optische Anordnung umgibt.

Bei einer weiteren Weiterbildung weist die optische Anordnung eine Trocknungseinrichtung zur Trocknung des Inertgases vor der Zuführung in den Innenraum auf. Die Trocknung des zugeführten Inertgases, z.B. in Form eines Edelgases, ist günstig, um in dem Innenraum einen möglichst niedrigen Wasser-Partialdruck sowie einen möglichst niedrigen Sauerstoff-Partialdruck zu erzeugen. Für die Trocknung kann eine handelsübliche Trocknungs- bzw. Reinigungseinrichtung ("gas purifier") verwendet werden, wie sie zur Reinigung bzw. zur Trocknung von Inertgasen, z.B. zur Trocknung von Argon, verwendet wird.

Bei einer Ausführungsform ist Wasser mit einem Gehalt von weniger als 1 ppmV, bevorzugt von weniger als 0,1 ppmV in den Innenraum eingebracht. Wie weiter oben beschrieben wurde, ist es günstig, wenn der Gehalt bzw. der Partialdruck von Wasser in dem Innenraum möglichst gering ist, damit bei photochemischen Reaktionen mit der Strahlung im FUV/VUV-Wellenlängenbereich möglichst wenige reaktive Spezies gebildet werden. Dies ist insbesondere günstig bzw. erforderlich, wenn optische Elemente in dem Innenraum vorhanden sind, die eine hohe Affinität zur Oxidbildung haben, beispielsweise Aluminium.

Bei einer Ausführungsform weist die reflektierende Beschichtung des mindestens einen reflektierenden optischen Elements mindestens eine Aluminium-Schicht auf. Optische Elemente zur Reflexion von FUV/VUV-Strahlung weisen typischerweise eine reflektierende Beschichtung auf, die bei bestimmten Anwendungen, beispielsweise bei der Inspektion von Wafern, über einen großen Spektralbereich innerhalb des FUV/VUV-Wellenlängenbereichs eine hohe Reflektivität aufweisen sollten. Da Aluminium im FUV/VUV-Wellenlängenbereich eine hohe Reflektivität von ca. 0,9 bzw. 90% besitzt, hat es sich als günstig erwiesen, wenn eine solche reflektierende Beschichtung eine oder ggf. mehrere Aluminium-Schichten als Basisschicht(en) aufweist. Das reflektierende optsiche Element kann auch als Rückflächenspiegel ausgebildet sein. In diesem Fall ist die Alumnium-Schicht an der Rückseite eines für die FUV/VUV-Strahlung transparenten, z.B. fluoridischen Substrats aufgebracht.

Bei der Verwendung von Aluminium-Schichten besteht generell das Problem, dass die Aluminium-Schicht beim Kontakt zu einer das reflektive optische Element umgebenden Atmosphäre praktisch sofort eine native Aluminiumoxid(Al₂O₃)-Schicht ausbildet, die eine Schichtdicke in der Größenordnung von ca. 2-3 nm aufweist. Diese Al₂O₃-Schicht absorbiert im VUV-Wellenlängenbereich so stark, dass eine Aluminium-Schicht als reflektierende Schicht für den Einsatz im VUV-Wellenlängenbereich ohne das Vorsehen weiterer Maßnahmen, welche diese vor Oxidation schützen, nicht attraktiv ist.

Bei einer Weiterbildung ist auf die reflektierende Beschichtung mindestens eine Schutzschicht aus einem fluoridischen Material aufgebracht. Um die Aluminium-Schicht vor Oxidation zu schützen, ist es beispielsweise aus dem Artikel "Protected and enhanced aluminum mirrors for the VUV" von S. Wilbrandt et al., Applied Optics, Vol. 53, No. 4, Februar 2014 bekannt, Schutzschichten bzw. Schutzbeschichtungen in Form von Metall-Flouriden auf die Aluminium-Schicht aufzubringen, z.B. in Form von MgF₂, AlF₃ oder LiF.

Es ist allerdings beobachtet worden, dass bei hohen Strahlungsintensitäten, wie sie in der Lithographie und besonders auch bei der Inspektion von Masken und Wafern vorkommen können, trotz der oben beschriebenen Schutzschichten bereits innerhalb weniger Stunden oder Tage eine starke Degradation der reflektierenden optischen Elemente stattfindet, die mit einem hohen Reflektivitätsverlust einhergeht, wenn der Sauerstoff- bzw. Wasser-Gehalt in dem Innenraum bzw. in der Umgebung zu groß ist. Daher sollte der neben dem Gehalt an Wasser auch der Gehalt an Sauerstoff in dem Innenraum möglichst gering gewählt werden.

Bei einer weiteren Ausführungsform weist die optische Anordnung mindestens eine Vakuum-Pumpe zur Evakuierung des Innenraums auf. Bei dieser Ausführungsform wird in der Regel in dem Innenraum ein Gesamt-Druck erzeugt, der bei weniger als ca. 10⁻³ mbar liegt. In diesem Beispiel kann dem Innenraum ebenfalls ein Inertgas zugeführt werden, dies ist aber nicht zwingend der Fall.

Bei einer Weiterbildung dieser Ausführungsform liegt ein Partialdruck von Ammoniak in dem Innenraum bei mehr als 10⁻⁴ mbar, bevorzugt bei mehr als 10⁻³ mbar. Bei einem Partialdruck von Ammoniak, der oberhalb der angegebenen Werte liegt, kann eine Degradation der Oberfläche eines ionischen Kristalls typischerweise unterdrückt und somit die Lebensdauer des transmittierenden optischen Elements und damit der gesamten optischen Anordnung erhöht werden.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

### Zeichnung

Ausführungsbeispiele sind in der schematischen Zeichnung dargestellt und werden in der nachfolgenden Beschreibung erläutert. Es zeigt
- Fig. 1: eine schematische Darstellung einer optischen Anordnung für den VUV-Wellenlängenbereich in Form einer VUV-Lithographieanlage, sowie
- Fig. 2: eine schematische Darstellung einer optischen Anordnung für den VUV-Wellenlängenbereich in Form eines Wafer-Inspektionssystems.

In der folgenden Beschreibung der Zeichnungen werden für gleiche bzw. funktionsgleiche Bauteile identische Bezugszeichen verwendet.

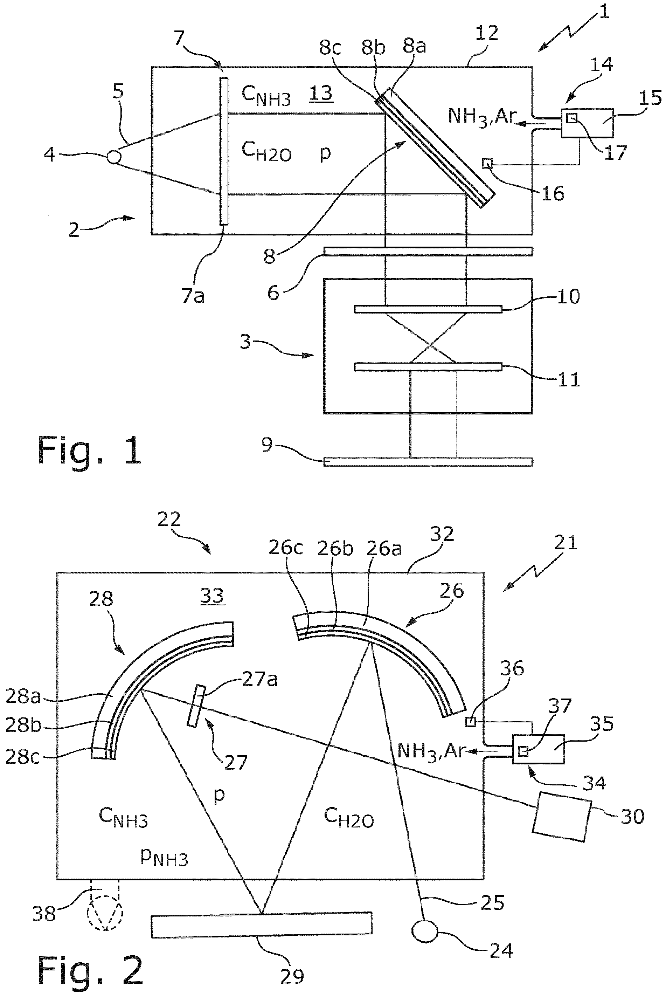

In **Fig. 1** ist schematisch eine optische Anordnung **1** in Form einer VUV-Lithographieanlage, insbesondere für Wellenlängen im Bereich zwischen 100 nm und 200 nm bzw. 190 nm, dargestellt. Die VUV-Lithographieanlage 1 weist als wesentliche Bestandteile zwei optische Systeme in Form eines Beleuchtungssystems **2** und eines Projektionssystems **3** auf. Für die Durchführung eines Belichtungsprozesses weist die VUV-Lithographieanlage 1 eine Strahlungsquelle **4** auf, bei der es sich beispielsweise um einen Excimer-Laser handeln kann, der Strahlung **5** bei einer Wellenlänge im VUV-Wellenlängenbereich von beispielsweise 193 nm, 157 nm oder 126 nm emittiert und der integraler Bestandteil der VUV-Lithographieanlage 1 sein kann.

Die von der Strahlungsquelle 4 emittierte Strahlung 5 wird mit Hilfe des Beleuchtungssystems 2 so aufbereitet, dass damit eine Maske **6,** auch Retikel genannt, ausgeleuchtet werden kann. Bei dem in Fig. 1 dargestellten Beispiel weist das Beleuchtungssystem 2 sowohl transmittierende als auch reflektierende optische Elemente auf. Stellvertretend sind in Fig. 1 ein transmittierendes optisches Element **7,** welches die Strahlung 5 bündelt, sowie ein reflektives optisches Element **8** dargestellt, welches die Strahlung 5 beispielsweise umlenkt. In bekannter Weise können in dem Beleuchtungssystem 2 verschiedenste transmittierende, reflektierende oder sonstige optische Elemente in beliebiger, auch komplexerer Weise miteinander kombiniert werden.

Die Maske 6 weist auf ihrer Oberfläche eine Struktur auf, die auf ein zu belichtendes optisches Element **9,** beispielsweise einen Wafer, im Rahmen der Produktion von Halbleiterbauelementen, mithilfe des Projektionssystems 3 übertragen wird. Im gezeigten Beispiel ist die Maske 6 als transmittierendes optisches Element ausgebildet. In alternativen Ausführungen kann die Maske 6 auch als reflektierendes optisches Element ausgebildet sein. Das Projektionssystem 2 weist im dargestellten Beispiel mindestens ein transmittierendes optisches Element auf. Im gezeigten Beispiel sind stellvertretend zwei transmittierende optische Elemente **10, 11** dargestellt, die beispielsweise dazu dienen, die Strukturen auf der Maske 6 auf die für die Belichtung des Wafers 9 gewünschte Größe zu verkleinern. Auch bei dem Projektionssystem 3 können u.a. reflektive optische Elemente vorgesehen sein und beliebige optische Elemente können in bekannter Weise beliebig miteinander kombiniert werden. Es sei darauf hingewiesen, dass auch optische Anordnungen ohne transmissive optische Elemente für die VUV-Lithographie eingesetzt werden können.

In **Fig. 2** ist schematisch eine beispielhafte Ausführung einer optischen Anordnung in Form eines Wafer-Inspektionssystems **21** dargestellt. Die nachstehenden Erläuterungen gelten analog auch für Inspektionssysteme zur Inspektion von Masken.

Das Wafer-Inspektionssystem 21 weist ein optisches System **22** mit einer Strahlungsquelle **24** auf, deren Strahlung **25** mittels des optischen Systems 22 auf einen Wafer **29** gelenkt wird. Zu diesem Zweck wird die Strahlung 25 von einem konkaven Spiegel **26** auf den Wafer 29 reflektiert. Bei einem Masken-Inspektionssystem 2 könnte man anstelle des Wafers 29 eine zu untersuchende Maske anordnen. Die vom Wafer 29 reflektierte, gebeugte und/oder gebrochene Strahlung wird von einem ebenfalls zu dem optischen System 22 gehörigen weiteren konkaven Spiegel **28** über ein transmittierendes optisches Element **27** auf einen Detektor **30** zur weiteren Auswertung geleitet. Bei der Strahlungsquelle 24 kann es sich beispielsweise um genau eine Strahlungsquelle oder um eine Zusammenstellung von mehreren einzelnen Strahlungsquellen handeln, um ein im Wesentlichen kontinuierliches Strahlungsspektrum zur Verfügung zu stellen. In Abwandlungen kann auch eine oder es können mehrere schmalbandige Strahlungsquellen 24 eingesetzt werden. Bevorzugt liegt die Wellenlänge bzw. das Wellenlängenband der von der Strahlungsquelle 24 erzeugten Strahlung 25 im Bereich zwischen 100 nm und 200 nm, besonders bevorzugt zwischen 110 nm und 190 nm.

Bei dem in Fig. 1 gezeigten Beispiel weist das Beleuchtungssystem 2 ein Gehäuse **12** auf, in dem ein Innenraum **13** gebildet ist, in dem das transmissive optische Element 7 sowie das reflektierende optische Element 8 in Form des Spiegels angeordnet sind. Entsprechend weist auch das optische System 22 des Wafer-Inspektionssystems 2 von Fig. 2 ein Gehäuse **32** auf, in dem ein Innenraum **33** gebildet ist, in dem die beiden Spiegel 26, 28 sowie das transmissive optische Element 27 angeordnet sind.

Bei der Bestrahlung des jeweiligen transmittierenden optischen Elements 7, 27 mit der Strahlung 5, 25 der Strahlungsquelle 4, 24, die typischerweise eine hohe Intensität aufweist, kann es insbesondere für den Fall, dass das transmittierende optische Element 7, 27 ein Substrat **7a, 27a** in Form eines ionischen Kristalls, z.B. in Form von MgF₂ aufweist, durch den Energieeintrag zu einer Umlagerung der gegenüber dem Innenraum 13, 33 freiliegenden Oberflächen des Substrats 7a, 27a kommen. Diese Umlagerung kann eine Degradation der Oberflächen insbesondere in Form einer Aufrauhung der Oberflächen zur Folge haben. Eine solche Aufrauhung während des Betriebs der optischen Anordnung 1, 21 ist nicht erwünscht, da die Aufrauhung eine Vergrößerung der jeweiligen Oberfläche zur Folge hat, welche die Anlagerung von kontaminierenden Stoffen an der Oberfläche des Substrats 7a, 27a eines jeweiligen transmittierenden optischen Elements 7, 27 begünstigt. Auch kann die Aufrauhung der Oberflächen des Substrats 7a, 27a zu einer Streulichtbildung innerhalb der jeweiligen optischen Anordnung 1, 21 führen.

Um eine Umlagerung der Oberflächen des kristallinen Substrats 7a des transmittierenden optischen Elements 7 zu verhindern, weist die Lithographieanlage 1 einen Gaseinlass **14** auf, der zur Zuführung eines Adsorbats in Form von Ammoniak **NH₃** in den Innenraum 13 des Gehäuses 12 des Beleuchtungssystems 2 dient. Entsprechend weist auch das Wafer-Inspektionssystem 21 einen Gaseinlass **34** auf, der zur Zuführung eines Adsorbats in Form von Ammoniak NH₃ in den Innenraum 33 des Gehäuses 32 des optischen Systems 22 dient. Bei den in Fig. 1 und Fig. 2 gezeigten Beispielen wird dem jeweiligen Innenraum 13, 33 zusätzlich zu dem Adsorbat in Form von Ammoniak NH₃ auch ein Inertgas in Form eines Edelgases, genauer gesagt in Form von Argon **Ar,** zugeführt. Der Gaseinlass 14, 34 bzw. das Gaseinlasssystem für die Zuführung des Ammoniaks NH₃ in den jeweiligen Innenraum 13, 33 weist ein Reservoir auf, in dem der Ammoniak NH₃ enthalten ist.

Die Konzentration bzw. der Gehalt c_{NH3} des Ammoniaks NH₃ in dem jeweiligen Innenraum 13, 33 liegt bei mehr als 0,1 ppmV, ggf. bei mehr als 1 ppmV, um eine möglichst große Bedeckung der Oberflächen der jeweiligen transmittierenden optischen Elemente 7, 27 mit Ammoniak NH₃ zu erreichen. Der Gehalt an Ammoniak NH₃ in dem jeweiligen Innenraum 13, 33 sollte in der Regel bei nicht mehr als ca. 10 ppmV liegen. Alternativ oder zusätzlich zu Argon Ar kann ein anderes Inertgas, beispielsweise ein anderes Edelgas, oder Stickstoff N₂ in den jeweiligen Innenraum 13, 33 eingebracht werden.

Da es sich bei Ammoniak NH₃ um ein toxisches Gas handelt, ist der Gaseinlass 14, 34 ausgebildet ist, den Ammoniak NH₃ und das Inertgas Ar gemeinsam als Gasgemisch in den jeweiligen Innenraum 13, 33 einzubringen. Zu diesem Zweck kann der Gaseinlass 14, 34 ein nicht bildlich dargestelltes Mischventil aufweisen. Auf diese Weise kann erreicht werden, dass der MAK-Wert für die Konzentration von Ammoniak von 20 ml/m³ beim Zuführen des Ammoniaks NH₃ nicht überschritten wird.

Um die Konzentration c_{NH3} des Ammoniaks NH₃ in dem jeweiligen Innenraum 13, 33 einzustellen, weisen die Lithographieanlage 1 von Fig. 1 und das Wafer-Inspektionssystem 21 von Fig. 2 jeweils eine Einstelleinrichtung **15, 35** auf, welche auf ein steuerbares Ventil einwirkt, um den Durchfluss von Ammoniak NH₃ durch den Gaseinlass 14, 34 einzustellen bzw. zu regeln. Im gezeigten Beispiel ist zudem eine Messeinrichtung **16, 36** in dem jeweiligen Innenraum 13, 33 angeordnet, um die Ist-Konzentration c_{NH3} von Ammoniak NH₃ in dem jeweiligen Innenraum 13, 33 zu messen. Bei der Messeinrichtung 16, 36 kann es sich beispielsweise um einen Restgasanalysator handeln, der zur Bestimmung der Ist-Konzentration c_{NH3} des Ammoniaks NH₃ ein Massenspektrometer aufweist. Bei der Messeinrichtung 16, 36 kann es sich auch um einen elektrochemischen Sensor oder um einen durchstimmbaren Diodenlaser zur Durchführung von photoakustischer Spektroskopie handeln. Alternativ kann die Messeinrichtung 16, 36 außerhalb des Innenraums 13, 33 angeordnet sein, aber mit diesem über eine Rohrleitung oder dergleichen verbunden sein. Die Einstelleinrichtung 15, 35 weist einen Regler auf, um den gemessenen Wert der Ammoniak-Konzentration c_{NH3} auf einen Soll-Wert bzw. auf ein Soll-Intervall zu regeln.

Die Zuführung eines polaren Adsorbats in Form von Ammoniak NH₃ an Stelle von Wasser H₂O ist günstig, da sich bei photoinduzierten chemischen Reaktionen von Ammoniak NH₃ mit der Strahlung 5, 25 im VUV-Wellenlängenbereich vergleichsweise wenig reaktive Reaktionsprodukte bilden. Bei photoinduzierten chemischen Reaktionen der Strahlung 5, 25 im VUV-Wellenlängenbereich mit Wasser H₂O werden hingegen stark reaktive Reaktionsprodukte z.B. in Form von Sauerstoff-Radikalen, von Wasserstoff-Radikalen, etc. gebildet. Die Zuführung von Wasser H₂O kann daher zu unerwünschten Effekten wie z.B. zur Oxidation von funktionalen optischen Schichten oder Komponenten führen, die in dem Innenraum 13, 33 angeordnet sind.

Während des Betriebs von optischen Anordnungen wie z.B. der VUV-Lithographieanlage 1 von Fig. 1 oder des Wafer- oder Masken-Inspektionssystems 2 von Fig. 2 kann es aufgrund dieser stark reaktiven Reaktionsprodukte beim Vorhandensein einer vergleichsweise großen Konzentration von Wasser H₂O in dem jeweiligen Innenraum 13, 33 insbesondere zu einer Oxidation der Oberflächen der reflektierenden optischen Elemente 8, 26, 27 kommen, deren Aufbau nachfolgend näher beschrieben wird.

Die reflektierenden optischen Elemente 8, 26, 28 weisen ein Substrat **8a, 26a, 28a** z.B. aus einem fluoridischen Material oder aus Silizium auf, auf welches eine reflektierende Beschichtung **8b, 26b, 28b** zur Reflexion der VUV-Strahlung 5, 35 aufgebracht ist. Als reflektierende Beschichtung 8b, 26b, 28b weisen die reflektierenden optischen Elemente 8, 26, 28 jeweils eine Metallverspiegelung in Form einer Aluminium-Schicht auf. Zum Schutz der reflektierenden Beschichtung 8b, 26b, 28b vor Oxidation ist bei den in Fig. 1 und Fig. 2 gezeigten Beispielen eine Schutzschicht **8c, 26c, 28c** aus einem fluoridischen Material, zum Beispiel aus MgF₂, AlF₃, LiF, LaF₃, GdF₃, BaF₂ oder anderen transparenten Fluoriden aufgebracht.

Der Schutz der reflektierenden Beschichtung 8b, 26b, 28b in Form der Aluminium-Schicht durch die Schutzschicht 8c, 26c, 28c ist jedoch nur wirksam, wenn der Wasser-Gehalt und auch der Sauerstoff-Gehalt in dem jeweiligen Innenraum 13, 33 äußerst gering sind. Insbesondere sollte der Wasser-Gehalt c_{H2O} in dem jeweiligen Innenraum 13, 33 bei weniger 1 ppmV, insbesondere bei weniger als 0,1 ppmV liegen.

Um eine möglichst geringe Wasser-Konzentration sowie eine geringe Sauerstoff-Konzentration in dem jeweiligen Innenraum 13, 33 zu gewährleisten, weist die jeweilige optische Anordnung 1, 21 von Fig. 1 bzw. von Fig. 2 eine Trocknungseinrichtung **17, 37** zur Trocknung des Inertgases Ar vor der Zuführung in den Innenraum 13, 33 auf. Als Trocknungseinrichtung 17, 37 kann eine herkömmliche Gas-Reinigungseinrichtung ("gas purifier") verwendet werden, die neben Wasser auch andere unerwünschte Gasbestandteile, z.B. Sauerstoff, filtert.

Der (Gesamt-)Druck p in dem jeweiligen Innenraum 13, 33 liegt in den in Fig. 1 und Fig. 2 gezeigten Beispielen jeweils ungefähr bei Atmosphärendruck. Bei einer anderen Ausgestaltung des Wafer-Inspektionssystems 2 (oder der Lithographieanlage 1) kann eine in Fig. 2 gestrichelt dargestellte Vakuum-Pumpe **38** mit dem Innenraum 33 in Verbindung stehen, um diesen zu evakuieren. Mit Hilfe der Vakuum-Pumpe 38 kann in dem Innenraum 33 ein Gesamt-Druck p erzeugt werden, der bei ca. 10⁻³ mbar oder darunter liegt.

Um in diesem Fall eine ausreichende Bedeckung der Oberflächen des Substrats 7a des transmittierenden optischen Elements 7 zu erzeugen, ist ein Partialdruck p_{NH3} von Ammoniak NH₃ in dem Innenraum 33 von typischerweise mehr als 10⁻⁴ mbar, bevorzugt von mehr als 10⁻³ mbar erforderlich. Es versteht sich, dass auch der Innenraum 13 des Beleuchtungssystems 2 des in Fig. 1 gezeigten Lithographiesystems 1 mit Hilfe einer Vakuum-Pumpe evakuiert werden kann. Auch können die in dem Innenraum des Projektionssystems 3 von Fig. 1 angeordneten transmittierenden optischen Elemente 10, 11 auf die weiter oben in Zusammenhang mit dem Innenraum 13 des Beleuchtungssystems 2 beschriebene Weise vor Degradation geschützt werden.

Bei den oben beschriebenen optischen Anordnungen 1, 2 kann auf aufgrund der Zudosierung von Ammoniak NH₃ die Lebensdauer von transmittierenden optischen Elementen 7, 27 erhöht werden, ohne dass hierbei die Lebensdauer der reflektierenden optischen Elemente 8, 26, 28 gesenkt wird, wie dies bei der Zuführung von Wasser H₂O in den jeweiligen Innenraum 13, 33 der Fall wäre. Zudem kann auf das Vorsehen einer Dosiereinrichtung für Wasser verzichtet werden. Auch die Lebensdauer der reflektierenden optischen Elemente 8, 26, 28 kann auf diese Weise erhöht werden, insbesondere wenn diese anders als in Fig. 1 und in Fig. 2 dargestellt als Rückflächen-Spiegel ausgebildet sind. Die Zuführung von Ammoniak NH₃ kann auch vorteilhaft bei optischen Anordnungen 1, 2 eingesetzt werden, die für den Betrieb im FUV-Wellenlängenbereich zwischen ca. 200 nm und ca. 280 nm ausgelegt sind. Es versteht sich, dass die weiter oben beschriebene Zudosierung von Ammoniak auch bei optischen Anordnungen 1, 2 erfolgen kann, bei denen nur transmittierende optische Elemente 7, 27 oder bei denen nur reflektierende optische Elemente 8, 26, 28 in dem jeweiligen Innenraum 13, 33 angeordnet sind.

## Patentansprüche

1. Optische Anordnung für den FUV/VUV-Wellenlängenbereich, insbesondere FUV/VUV-Lithographieanlage (1) oder Wafer-Inspektionssystem (2), umfassend:
einen Innenraum (13, 33),
wobei in dem Innenraum (13, 33) mindestens ein transmittierendes optisches Element (7, 27) zur Transmission von Strahlung (5, 25) im FUV/VUV-Wellenlängenbereich angeordnet ist, welches bevorzugt ein kristallines, insbesondere ionisches Substrat (7a, 27a) aufweist,
und/oder
wobei in dem Innenraum (13, 33) mindestens ein reflektierendes optisches Element (8, 26, 28) zur Reflexion von Strahlung (5, 25) im FUV/VUV-Wellenlängenbereich angeordnet ist, das ein Substrat (8a, 26a, 28a) und eine reflektierende Beschichtung (8b, 26b, 28b) aufweist,
eine Strahlungsquelle (4, 24) zur Bestrahlung des optischen Elements (7, 8, 26, 27, 28) mit Strahlung (5, 25) im FUV/VUV-Wellenlängenbereich, sowie mindestens einen Gaseinlass (14, 34) zur Zuführung mindestens eines Gases in den Innenraum (13, 33),
**dadurch gekennzeichnet,**
**dass** der Gaseinlass (14, 34) zur Zuführung von Ammoniak (NH₃) in den Innenraum (13, 33) zumindest während der Bestrahlung des optischen Elements (7, 8, 26, 27, 28) ausgebildet ist und dass der Gaseinlass (14, 34) ein Reservoir aufweist, in dem der Ammoniak (NH₃) enthalten ist.

2. Optische Anordnung nach einem der vorhergehenden Ansprüche, weiter umfassend:
eine Einstelleinrichtung (15, 35) zur Einstellung eines Gehalts (c_{NH3}) des Ammoniaks (NH₃) in dem Innenraum (13, 33).

3. Optische Anordnung nach Anspruch 1 oder 2, welche eine Messeinrichtung (16, 36) zum Messen eines Gehalts (c_{NH3}) des Ammoniaks (NH₃) in dem Innenraum (13, 33) umfasst.

4. Optische Anordnung nach einem der vorhergehenden Ansprüche, bei welcher Ammoniak (NH₃) mit einem Gehalt (c_{NH3}) von mehr als 0,1 ppmV, bevorzugt von mehr als 1 ppmV, in den Innenraum (13, 33) eingebracht ist.

5. Optische Anordnung nach einem der vorhergehenden Ansprüche, welche zur Zuführung mindestens eines Inertgases in den Innenraum (13, 33), insbesondere über den Gaseinlass (14, 34), ausgebildet ist.

6. Optische Anordnung nach Anspruch 5, bei welcher der Gaseinlass (14, 34) ausgebildet ist, den Ammoniak (NH₃) und das Inertgas (Ar) als Gasgemisch in den Innenraum (13, 33) einzubringen.

7. Optische Anordnung nach Anspruch 5 oder 6, welche eine Trocknungseinrichtung (17, 37) zur Trocknung des Inertgases (Ar) vor der Zuführung in den Innenraum (13, 33) aufweist.

8. Optische Anordnung nach einem der vorhergehenden Ansprüche, bei der Wasser (H₂O) mit einem Gehalt (c_{H2O}) von weniger als 1 ppmV, bevorzugt von weniger als 0,1 ppmV in den Innenraum (13, 33) eingebracht ist.

9. Optische Anordnung nach einem der vorhergehenden Ansprüche, bei dem die reflektierende Beschichtung (8b, 26b, 28b) des reflektierenden optischen Elements (8, 26, 28) mindestens eine Aluminium-Schicht umfasst.

10. Optische Anordnung nach Anspruch 9, bei dem auf die reflektierende Beschichtung (8b, 26b, 28b) mindestens eine Schutzschicht (8c, 26c, 28c) aus einem fluoridischen Material aufgebracht ist.

11. Optische Anordnung nach einem der vorhergehenden Ansprüche, welche mindestens eine Vakuum-Pumpe (38) zur Evakuierung des Innenraums (33) aufweist.

12. Optische Anordnung nach Anspruch 11, bei der ein Partialdruck (p_{NH3}) von Ammoniak (NH₃) in dem Innenraum (33) bei mehr als 10⁻⁴ mbar, bevorzugt bei mehr als 10⁻³ mbar liegt.

## Claims

1. Optical arrangement for the FUV/VUV wavelength range, especially FUV/VUV lithography system (1) or wafer inspection system (2), comprising:
an interior (13, 33),
in which interior (13, 33) at least one transmitting optical element (7, 27) for transmission of radiation (5, 25) in the FUV/VUV wavelength range is disposed, which preferably has a crystalline, especially ionic, substrate (7a, 27a),
and/or
in which interior (13, 33) at least one reflective optical element (8, 26, 28) for reflection of radiation (5, 25) in the FUV/VUV wavelength range is disposed, having a substrate (8a, 26a, 28a) and a reflective coating (8b, 26b, 28b),
a radiation source (4, 24) for irradiating the optical element (7, 8, 26, 27, 28) with radiation (5, 25) in the FUV/VUV wavelength range, and at least one gas inlet (14, 34) for supplying at least one gas to the interior (13, 33),
**characterized in that**
the gas inlet (14, 34) is designed to supply ammonia (NH₃) to the interior (13, 33) at least during the irradiation of the optical element (7, 8, 26, 27, 28) and **in that** the gas inlet (14, 34) has a reservoir containing ammonia (NH₃).

2. Optical arrangement according to any of the preceding claims, further comprising:
a setting device (15, 35) for setting a content (c_{NH3}) of the ammonia (NH₃) in the interior (13, 33).

3. Optical arrangement according to Claim 1 or 2, comprising a measurement device (16, 36) for measuring a content (c_{NH3}) of the ammonia (NH₃) in the interior (13, 33).

4. Optical arrangement according to any of the preceding claims, in which ammonia (NH₃) has been introduced into the interior (13, 33) with a content (c_{NH3}) of more than 0.1 ppmv, preferably of more than 1 ppmv.

5. Optical arrangement according to any of the preceding claims, designed to supply at least one inert gas to the interior (13, 33), especially via the gas inlet (14, 34).

6. Optical arrangement according to Claim 5, in which the gas inlet (14, 34) is designed to introduce the ammonia (NH₃) and the inert gas (Ar) into the interior (13, 33) as a gas mixture.

7. Optical arrangement according to Claim 5 or 6, having a drying device (17, 37) for drying the inert gas (Ar) prior to supply to the interior (13, 33).

8. Optical arrangement according to any of the preceding claims, in which water (H₂O) has been introduced into the interior (13, 33) with a content (c_{H2O}) of less than 1 ppmv, preferably of less than 0.1 ppmv.

9. Optical arrangement according to any of the preceding claims, in which the reflective coating (8b, 26b, 28b) of the reflective optical element (8, 26, 28) comprises at least one aluminium layer.

10. Optical arrangement according to Claim 9, in which at least one protective layer (8c, 26c, 28c) composed of a fluoridic material has been applied to the reflective coating (8b, 26b, 28b).

11. Optical arrangement according to any of the preceding claims, having at least one vacuum pump (38) for evacuating the interior (33).

12. Optical arrangement according to Claim 11, in which a partial pressure (p_{NH3}) of ammonia (NH₃) in the interior (33) is more than 10⁻⁴ mbar, preferably more than 10⁻³ mbar.

## Revendications

1. Agencement optique pour la plage de longueurs d'onde FUV/VUV, en particulier un appareil lithographique FUV/VUV (1) ou un système d'inspection de tranche (2), comprenant :
un espace intérieur (13, 33),
au moins un élément optique de transmission (7, 27) destiné à la transmission d'un rayonnement (5, 25) dans la plage de longueurs d'onde FUV/VUV étant disposé dans l'espace intérieur (13, 33), lequel comporte de préférence un substrat cristallin, en particulier ionique (7a, 27a), et/ou
au moins un élément optique réfléchissant (8, 26, 28) destiné à la réflexion du rayonnement (5, 25) dans la plage de longueurs d'onde FUV/VUV étant disposé dans l'espace intérieur (13, 33), lequel comporte un substrat (8a, 26a, 28a) et un revêtement réfléchissant (8b, 26b, 28b),
une source de rayonnement (4, 24) destinée à irradier l'élément optique (7, 8, 26, 27, 28) avec un rayonnement (5, 25) dans la plage de longueurs d'onde FUV/VUV, ainsi qu'au moins une entrée de gaz (14, 34) destinée à délivrer au moins un gaz dans l'espace intérieur (13, 33),
**caractérisé en ce que**
l'entrée de gaz (14, 34) est conçue pour délivrer de l'ammoniac (NH₃) dans l'espace intérieur (13, 33), au moins pendant l'irradiation de l'élément optique (7, 8, 26, 27, 28) et **en ce que** l'entrée de gaz (14, 34) comporte un réservoir dans lequel est contenu l'ammoniac (NH₃).

2. Agencement optique selon l'une quelconque des revendications précédentes, comprenant en outre :
un dispositif de réglage (15, 35) destiné au réglage d'une teneur (c_{NH3}) de l'ammoniac (NH₃) dans l'espace intérieur (13, 33).

3. Agencement optique selon la revendication 1 ou 2, comprenant un moyen de mesure (16, 36) destiné à la mesure d'une teneur (c_{NH3}) de l'ammoniac (NH₃) dans l'espace intérieur (13, 33).

4. Agencement optique selon l'une quelconque des revendications précédentes, dans lequel de l'ammoniac (NH₃) ayant une teneur (c_{NH3}) supérieure à 0,1 ppmV, de préférence supérieure à 1 ppmV, est introduit dans l'espace intérieur (13, 33).

5. Agencement optique selon l'une quelconque des revendications précédentes, qui est conçu pour délivrer au moins un gaz inerte dans l'espace intérieur (13, 33), en particulier par l'intermédiaire de l'entrée de gaz (14, 34).

6. Agencement optique selon la revendication 5, dans lequel l'entrée de gaz (14, 34) est conçue pour introduire l'ammoniac (NH₃) et le gaz inerte (Ar) sous forme de mélange gazeux dans l'espace intérieur (13, 33).

7. Agencement optique selon la revendication 5 ou 6, qui comporte un dispositif de séchage (17, 37) destiné au séchage du gaz inerte (Ar) avant son introduction dans l'espace intérieur (13, 33).

8. Agencement optique selon l'une quelconque des revendications précédentes, dans lequel de l'eau (H₂O) ayant une teneur (C_{H2O}) inférieure à 1 ppmV, de préférence inférieure à 0,1 ppmV, est introduite dans l'espace intérieur (13, 33).

9. Agencement optique selon l'une quelconque des revendications précédentes, dans lequel le revêtement réfléchissant (8b, 26b, 28b) de l'élément optique réfléchissant (8, 26, 28) comprend au moins une couche d'aluminium.

10. Agencement optique selon la revendication 9, dans lequel au moins une couche de protection (8c, 26c, 28c) constituée d'un matériau à base de fluorure est déposée sur le revêtement réfléchissant (8b, 26b, 28b).

11. Agencement optique selon l'une quelconque des revendications précédentes, comportant au moins une pompe à vide (38) destinée à la mise sous vide de l'espace intérieur (33).

12. Agencement optique selon la revendication 11, dans lequel une pression partielle (p_{NH3}) d'ammoniac (NH₃) dans l'espace intérieur (33) se situe à plus de 10⁻⁴ mbar, de préférence à plus de 10⁻³ mbar.
